Europäisches Patentamt

European Patent Office

Office européen des brevets

(19)

(11) Publication number: **0 446 939 A2**

# EUROPEAN PATENT APPLICATION

(21) Application number: **91104008.7**

(22) Date of filing: **15.03.91**

(51) Int. Cl.5: **H01L 21/32**

(30) Priority: **16.03.90 JP 65669/90**

(43) Date of publication of application:
**18.09.91 Bulletin 91/38**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Adachi, Takao**
**2-16-4, Nokendai, Kanazawa-ku**
**Yokohama-shi, Kanagawa-ken(JP)**
Inventor: **Abe, Keiichi**
**4-12-3, Yachiyodai-Kita**
**Yachiyo-shi, Chiba-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Method of manufacturing semiconductor device.**

(57) In a method of manufacturing a semiconductor device, an insulating film (13) is formed on the surface of a semiconductor substrate (12); a resist film (14) is deposited on the surface of the insulating film (13); the resist film (14) is exposed for a first time by using a first mask (15a) having a pattern corresponding to a contact hole to be formed in the insulating film; the resist film (14) is exposed for a second time by using a second mask (15b) having a pattern corresponding to the contact hole (13a) and to an inclined portion (13b) to be formed at the peripheral portion of the contact hole; the resist film (14) is developed to remove a portion of the resist film corresponding to the contact hole (13a) and leave a portion having a thinner film thickness of the resist film corresponding to the inclined portion (13b) to be formed at the peripheral portion; and the insulating film (13) is etched to form the contact hole and the inclined portion at the peripheral portion respectively in the insulating film. The exposure processes using the first mask and the second mask are interchangeable.

FIG.IA

FIG.ID

## BACKGROUND OF THE INVENTION

The present invention relates to a method of manufacturing semi conductor devices, and more particularly to a method of forming contact holes.

A conventional method of forming contact holes will be described.

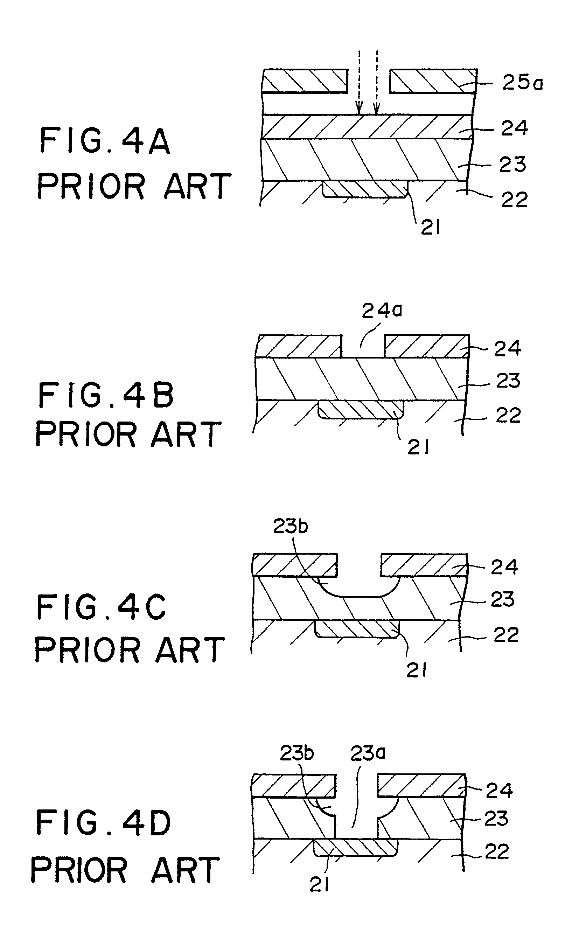

Figs. 4A to 4D show cross sectional views respectively at the processes of the conventional hole forming method. As shown in Fig. 4A, a first conductive layer 21 is formed in the surface part of a semiconductor substrate 22. After an insulating film 23 is formed on the surface of the first conductive layer 21, a second conductive layer (not shown) is formed thereon as a wiring layer. In order to have an electrical connection between the second conductive layer and the first conductive layer 21, it becomes necessary to form a contact hole in the insulating film 23. In order to improve step coverage of the second conductive layer, the periphery of the contact hole is made inclined. Such a contact hole is formed by the following manner.

A resist film 24 is formed on the surface of the insulating film 23. Then it is subjected to an exposure using a photo mask 25a (Fig. 4A) having a mask pattern corresponding to a contact hole.

A developing process is carried out to selectively remove an area 24a of the resist film 24 where a contact hole is to be formed (Fig. 4B).

In order for a contact hole to have an inclined or rounded periphery, an isotropic etching is carried out to remove a surface part 23b of the insulating film 23 (Fig. 4C).

An anisotropic etching process such as a reactive ion etching (RIE) is carried out to form a contact hole 23a in the first insulating film 23 (Fig. 4D).

As shown in Fig. 5, after the resist film 24 is removed, a second conductive layer 26 as an interconnection layer is formed on the surface of the insulating film 23 to thereby contact the second conductive layer 26 to the first conductive layer 21.

As described above, in the conventional method, an inclined portion is formed at the peripheral area 23b of the contact hole 23a by means of isotropic etching, and thereafter anisotropic etching is carried out to form the contact hole 23a.

There are the following problems, however, associated with such a conventional contact hole forming method.

In order to miniaturize a device element, the distance between holes and the like must be shortened. For this purpose, it is necessary to form an inclined area at a particular peripheral portion of the contact hole 23a. If the peripheral portion 23b of the contact hole is removed by means of isotropic etching, the inclined portion of the contact hole 23a is radially formed at the same distance from the center of the hole 23a, so that if the distance between contact holes is short, they may sometimes be electrically connected to each other. Thus, the work precision is lowered and a short-circuit occurs between interconnections. Furthermore, it is necessary to have an alignment margin between the contact hole and the conductive layer sufficiently larger than the diameter of the inclined portion, so that the distance between contact holes cannot be shortened, thus hindering miniaturization of device elements.

In addition, with the above conventional hole forming method, in order for a contact hole to have an inclined portion in a particular direction, it is necessary to provide at least two processes of removing insulating films, the process of making an inclined portion at the periphery of the contact hole, and the process of forming the contact hole. Namely, it is necessary to provide a lithography and etching process for making the inclined portion and a lithography and etching process for forming a contact hole, thus increasing the number of processes and lowering throughput.

## SUMMARY OF THE INVENTION

It is therefore an object of the present invention to provide a method of manufacturing a semiconductor device capable of miniaturizing device elements while minimizing an increase in the number of processes.

According to the present invention, there is provided a method of manufacturing a semiconductor device comprising the steps of: forming an insulating film on the surface of a semiconductor substrate; depositing a resist film on the surface of the insulating film; exposing the resist film for a first time by using a first mask having a pattern corresponding to a contact hole to be formed in the insulating film; exposing the resist film for a second time by using a second mask having a pattern corresponding to the contact hole and to an inclined portion to be formed at the peripheral portion of the contact hole; developing the resist film to remove a portion of the resist film corresponding to the contact hole and leave a portion having a thinner film thickness of the resist film corresponding to the inclined portion to be formed at the peripheral portion; and etching the insulating film to form the contact hole and the inclined portion at the peripheral portion respectively in the insulating film.

A resist film is exposed by using two types of masks for appropriate exposure times, one corresponding to a contact hole and the other corresponding to the contact hole and an inclined portion to be formed at the peripheral portion of the contact hole, to thereby remove the portion of the resist film corresponding to the contact hole and leave the portion having a thinner film thickness of the resist film corresponding to the inclined portion. By using the resist film thus formed, an insulating film is etched so that the portion of the insulating film corresponding to the contact hole is etched and the inclined portion is formed because of a presence of the resist film having a thinner film thickness. In this manner, a contact hole having an inclined portion at only a desired area can be formed, thereby allowing the distance between contact holes to be shortened and realize miniaturization of device elements, and further preventing an increase of the number of steps and improving throughput.

BRIEF DESCRIPTION OF THE DRAWINGS

In the accompanying drawings,
Figs. 1A-1D are cross sectional views showing processes of a method of manufacturing a semiconductor device according to an embodiment of this invention;
Figs. 2A-2D are cross sectional views showing processes of a method of manufacturing a semiconductor device according to another embodiment of this invention;
Fig. 3 is a perspective view of a contact hole formed in accordance with the embodiment method;
Figs. 4A-4D are cross sectional views at processes of a conventional method of manufacturing a semiconductor device; and
Fig. 5 is a cross sectional view having a wiring layer on the contact hole formed by the method illustrated with Fig. 3.

DESCRIPTION OF THE PREFERRED EMBODIMENT

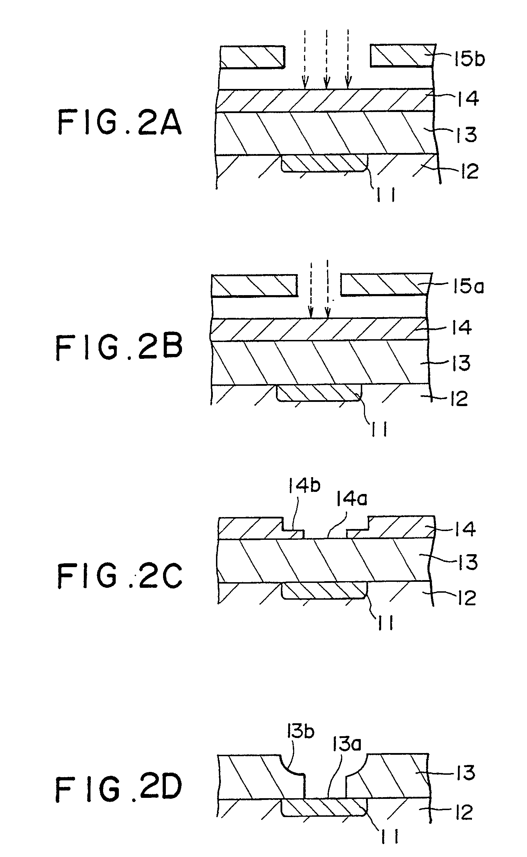

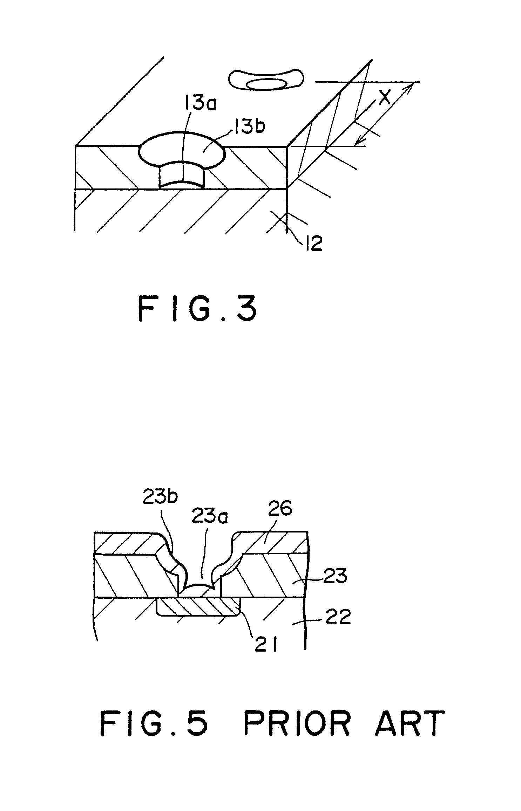

An embodiment of this invention will be described with reference to the accompanying drawings.

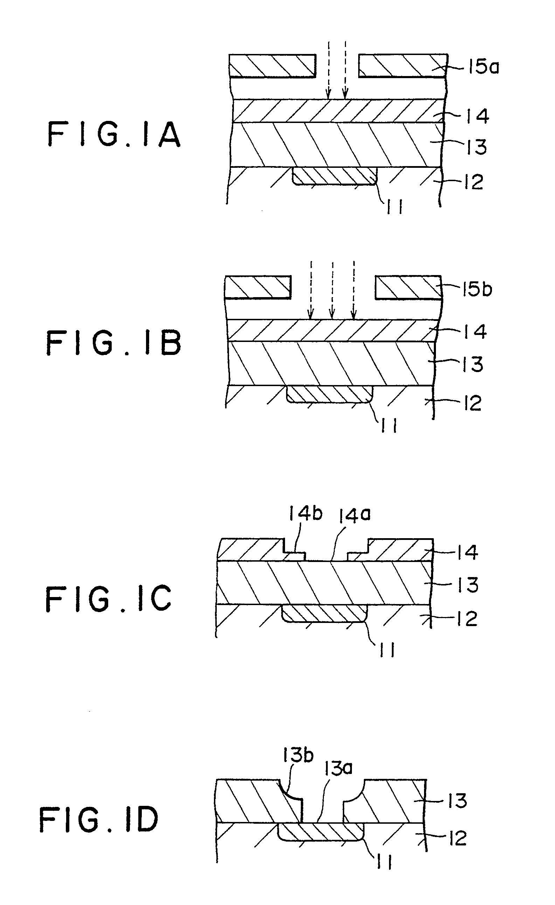

Figs. 1A to 1D are cross sectional views of a device element at respective processes of the manufacturing method according to the embodiment. On a first conductive region 11 formed in the surface part of a semiconductor substrate 12, there is formed an insulating film 13 on which further formed is a resist film 14. This resist film 14 is subjected to an exposure process using a first mask 15a having a pattern corresponding to a contact hole. This exposure is performed for a first time period shorter than the time period necessary for complete exposure by a second time period (Fig. 1A).
Then, the first mask 15a is replaced with a second mask 15b to again carry out an exposure process of the resist film 14 (Fig. 1B). This second mask 15b has a pattern corresponding not only to the contact hole itself but also to an inclined portion at the peripheral portion of the contact hole. This exposure is performed for the second time period.
After a development process, a portion 14a where the contact hole is to be formed is removed from the resist film 14, and there is left a portion 14b having a thinner film thickness where the inclined portion is to be formed (Fig. 1C). The processes starting from the resist coating process to the development process can be performed with the same processing apparatus.
Next, an anisotropic etching such as RIE is carried out. By properly setting the etching selection ratio, the portion of the insulating film 13 under the opening portion 14a without the resist film is first etched, and then the portion 14b having the thinner film thickness of the resist film 14 where the inclined portion is to be formed is etched, and thereafter the insulating film 13 under the portion 14 is gradually etched. Therefore, as shown in Fig. 1D, the insulating film 13 is formed such that it has a contact hole 13a and an inclined portion 13b at a particular peripheral portion thereof. For example, if the etching portion having a depth of 0.5 $\mu$M is to be formed in the insulating film 13 having a film thickness of 1.0 $\mu$m, the etching selection ratio is set to 5 and the second time duration is set such that the resist film 14b having a thickness of 0.1 $\mu$m is left at the region where the inclined portion is to be formed.
The contact hole 13a and its inclined portion 13b are shown in the perspective view of Fig. 3. Different from a conventional contact hole, the contact hole is not radially formed at the same distance from the center, but it is formed only in a particular direction. As a result, even if the distance between contact holes is shortened, contact holes will not be short-circuited thereby realizing miniaturization of device elements. This method requires only one etching process and one resist depositing and developing process. A conventional method requires two lithography processes and two etching processes. Thus, the number of processes is reduced with an additional time period only required for mask replacement and exposure, thereby improving throughput.
The above-described embodiment has been given for the illustrative purposes only, and is not intended to limit the scope of this invention. For example, the exposure process using the first mask shown in Fig. 1A may be carried out after the exposure process using the second mask shown in Fig. 1B as shown in Figs. 2A-2D. The order of these exposure processes is determined in accordance with the photosensitive characteristic of a resist.

Furthermore, the present invention is applicable to a method of forming holes in areas each having a different insulating film thickness and a different etching amount.

Reference signs in the claims are intended for better understanding and shall not limit the scope.

**Claims**

1. A method of manufacturing a semiconductor device comprising the steps of:

   forming an insulating film (13) on the surface of a semiconductor substrate (12);

   depositing a resist film on the surface of said insulating film;

   exposing said resist film' (14) for a first time by using a first mask (15a) having a pattern corresponding to a contact hole to be formed in said insulating film;

   exposing said resist film for a second time by using a second mask (15b) having a pattern corresponding to said contact hole and to an inclined portion to be formed at the peripheral portion of said contact hole;

   developing said resist film to remove a portion of said resist film corresponding to said contact hole and leave a portion having a thinner film thickness of said resist film corresponding to said inclined portion to be formed at said peripheral portion; and

   etching said insulating film to form said contact hole and said inclined portion at said peripheral portion respectively in said insulating film.

2. A method of manufacturing a semiconductor device comprising the steps of:

   forming an insulating film (13) on the surface of a semiconductor substrate (12);

   depositing a resist film on the surface of said insulating film;

   exposing said resist film (14) for a first time by using a first mask (15b) having a pattern corresponding to a contact hole to be formed in said insulating film and to an inclined portion to be formed at the peripheral portion of said contact hole;

   exposing said resist film for a second time by using a second mask (15a) having a pattern corresponding to said contact hole;

   developing said resist film to remove a portion of said resist film corresponding to said contact hole and leave a portion having a thinner film thickness of said resist film corresponding to said inclined portion to be formed at said peripheral portion; and

   etching said insulating film to form said contact hole and said inclined portion at said peripheral portion respectively in said insulating film.

FIG.IA

FIG.IB

FIG.IC

FIG.ID

FIG.2A

FIG.2B

FIG.2C

FIG.2D

# FIG. 3

# FIG.5  PRIOR ART

FIG.4A
PRIOR ART

25a
24
23
22
21

FIG.4B
PRIOR ART

24a
24
23
22
21

FIG.4C
PRIOR ART

23b
24
23
22
21

FIG.4D
PRIOR ART

23b    23a
24
23
22
21